# EUROPEAN PATENT APPLICATION

(11) **EP 4 730 495 A1**
(43) Date of publication of application: **22.04.2026**
(21) Application number: 25206724.4
(22) Date of filing: 03.10.2025
(51) Int. Cl.: H01M 50/103, H01M 50/176, H01M 50/516, H01M 50/519, H01M 50/545, H01M 50/553

(54) **BATTERY MODULE AND ELECTRONIC DEVICE USING THE SAME**

(30) Priority: 15.10.2024 KR 20240140162
(71) Applicant: SAMSUNG SDI CO., LTD., Yongin-si, Gyeonggi-do 17084 (KR)
(72) Inventor: KOH, Seok, 17084 YONGIN-SI (KR)
(74) Representative: Regimbeau

(57) **Abstract**

A battery module includes a first battery cell (100) including a first electrode assembly, a first case (120) accommodating the first electrode assembly, and a first flange portion (122) on the first case, and a second battery cell (200) including a second electrode assembly, a second case (220) accommodating the second electrode assembly, and a second flange portion (222) on the second case, wherein the first flange portion (122) and the second flange portion (222) are connected to each other.

## Description

### TECHNICAL FIELD

Embodiments of the present disclosure relate a battery module and an electronic device using the battery module.

### BACKGROUND

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (*e.g*., home and/or utility scale power storage). A secondary battery generally includes an electrode assembly composed of a positive electrode and a negative electrode, a case accommodating the same, and electrode terminals connected to the electrode assembly.

As the interest and demand for smaller and lighter electronic devices increases, power consumption is simultaneously increasing as device performance advances. In response, there is a desire and/or need for technologies that connect multiple battery cells into a module to supply higher power, while ensuring that the miniaturization and weight reduction characteristics of the battery module are met. Further, technologies that enable the reliable connection of multiple battery cells are also desired or required.

The above information disclosed in this Background section is for enhancement of understanding of the background of the present disclosure, and therefore, it may contain information that does not constitute related (or prior) art.

### SUMMARY

Aspects of one or more embodiments of the present disclosure provide a battery module and an electronic device using the battery module. For example, aspects of one or more embodiments of the present disclosure provide a battery module and an electronic device using the battery module providing a battery module having a reliable connection between the multiple battery cells.

However, the technical problem to be solved by the present disclosure is not limited to the above problem, and other problems not mentioned herein, and aspects and features of the present disclosure that would address such problems, will be clearly understood by those skilled in the art from the description of the present disclosure below.

According to one or more embodiments of the present disclosure, a battery module includes a first battery cell including a first electrode assembly, a first case accommodating the first electrode assembly, and a first flange portion on the first case, and a second battery cell including a second electrode assembly, a second case accommodating the second electrode assembly, and a second flange portion on the second case, wherein the first flange portion and the second flange portion are connected to each other.

According to one or more embodiments, the first flange portion may include a body flange portion and a cover flange portion. The first case may include a body portion including the body flange portion, the body portion having a first surface that may be opened to accommodate (*e.g*., defining an opening that accomodates) the first electrode assembly, and a case cover including the cover flange portion, the case cover covering the first surface of the body portion and sealing the first electrode assembly.

According to one or more embodiments, the cover flange portion and the case cover may be integrally formed (*e.g*., as a single piece) and located in a single plane.

According to one or more embodiments, the body portion and the case cover may be sealed by welding.

According to one or more embodiments, the first battery cell and the second battery cell may be connected and a case cover of the first case and a case cover of the second case face each other.

According to one or more embodiments, an adhesive material may be between the case cover of the first battery cell (*e.g*., of the first case) and the case cover of the second battery cell (*e.g*., of the second case), so that the first battery cell and the second battery cell may be fixedly coupled to each other.

According to one or more embodiments, the first flange portion may be welded to the second flange portion.

According to one or more embodiments, each of the first case and the second case may be a metal that may include stainless steel (SUS).

According to one or more embodiments, each of the first case and the second case may have a thickness in a range of about 0.05 mm to 0.1 mm.

According to one or more embodiments, the body portion including the body flange portion and the case cover including the cover flange portion may be formed by sealing an original body portion and a planar original case cover by welding, and then cutting the original body portion and the original case cover. The body portion comprising the body flange portion and the case cover comprising the cover flange portion are thus sealed along a welding line defining the first flange portion.

According to one or more embodiments, the first battery cell may include a first electrode terminal formed through (or on) the first case and a second electrode terminal in contact with the first case. The second battery cell may include a third electrode terminal through (or on) the second case and a fourth electrode terminal in contact with the second case. The first case of the first battery cell and the second case of the second battery cell may be electrically connected to each other through the first flange portion and the second flange portion.

According to one or more embodiments, each of the second electrode terminal and the fourth electrode terminal may include an electrode plate including a nickel (Ni) alloy.

According to one or more embodiments, the battery module may further include a protection circuit module arranged on the first battery cell and connected to both the first battery cell and the second battery cell.

According to one or more embodiments, the first battery cell may include a first electrode terminal through (or on) the first case and a second electrode terminal in contact with the first case. The second battery cell may include a third electrode terminal through (on or) the second case and a fourth electrode terminal in contact with the second case. The protection circuit module may include a first connection tab connecting the first electrode terminal of the first battery cell and the protection circuit module, a second connection tab connecting the second electrode terminal of the first battery cell and the protection circuit module, and a third connection tab connecting the third electrode terminal of the second battery cell and the protection circuit module.

According to one or more embodiments, the first electrode terminal and the third electrode terminal may be electrically connected to each other through the protection circuit module. The second electrode terminal and the fourth electrode terminal may be electrically connected to each other through the first flange portion and the second flange portion.

According to one or more embodiments, the protection circuit module may include a substrate on which protection circuit devices may be integrated, a lead-out portion extending from one side of the substrate, and a connector arranged on a surface of the lead-out portion and connected to an external device.

According to one or more embodiments, the substrate may include a flexible printed circuit board (FPCB).

According to one or more embodiments of the present disclosure, an electronic apparatus includes an operation unit configured to perform a set or predetermined operation, a housing accommodating and/or fixing the operation unit therein, and a battery module in the housing and configured to supply power to the operation unit. The battery module includes a first battery cell including a first electrode assembly, a first case accommodating the first electrode assembly, and a first flange portion on the first case, and a second battery cell including a second electrode assembly, a second case accommodating the second electrode assembly, and a second flange portion on the second case, and wherein the first flange portion and the second flange portion may be connected to each other.

According to one or more embodiments, the first flange portion may be welded to the second flange portion.

According to one or more embodiments, the first case of the first battery cell and the second case of the second battery cell may be electrically connected to each other through the first flange portion and the second flange portion.

According to one or more embodiments of the present disclosure, the flange portions are respectively formed on corresponding sides of the cases of the first and second battery cells, and these flange portions are welded together. Due to this connection, the first and second battery cells can be electrically connected without the need for separate fastening members, facilitating manufacturing and helping to reduce costs.

According to one or more embodiments of the present disclosure, the flange portion may be formed on one side of each of the cases of the first and second battery cells. This connection can protect the battery cell from welding damage during the welding connection process.

However, aspects and features of the present disclosure are not limited to those described above, and other aspects and features not mentioned will be clearly understood by a person skilled in the art from the detailed description, described below.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings.
FIG. 1 illustrates a perspective view of a battery module according to one or more embodiments of the present disclosure.
FIG. 2 illustrates a plan view of a battery module according to one or more embodiments of the present disclosure.
FIG. 3 illustrates an exploded view of a battery module according to one or more embodiments of the present disclosure.
FIG. 4 illustrates an exploded view of an electrode assembly and a case according to one or more embodiments of the present disclosure.
FIG. 5 illustrates an exploded view of a structure prior to an assembly of a first battery cell and a second battery cell, according to one or more embodiments of the present disclosure.
FIG. 6 illustrates a perspective view of a structure after an assembly of a first battery cell and a second battery cell, according to one or more embodiments of the present disclosure.
FIG. 7 illustrates a top perspective view of a protection circuit module according to one or more embodiments of the present disclosure.
FIG. 8 illustrates a bottom perspective view of a protection circuit module according to one or more embodiments of the present disclosure.
FIGS. 9 - 13 illustrate perspective views of a process of manufacturing a first battery cell according to one or more embodiments of the present disclosure.
FIG. 14 illustrates a schematic perspective view of an electronic apparatus including a battery according to one or more embodiments of the present disclosure.
FIG. 15 illustrates schematic view of a battery module arranged within an electronic apparatus according to one or more embodiments of the present disclosure.

### DETAILED DESCRIPTION

Hereinafter, embodiments of the present disclosure will be described, in detail, with reference to the accompanying drawings. The terms or words used in the present specification and claims are not to be limitedly interpreted as general or dictionary meanings and should be interpreted as meanings and concepts that are consistent with the technical idea of the present disclosure on the basis of the principle that an inventor can be his/her own lexicographer to appropriately define concepts of terms to describe his/her invention in the best way.

The embodiments described in this specification and the configurations shown in the drawings are only some of the embodiments of the present disclosure and do not represent all of the technical aspects and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof. Additionally, the terms "comprise(s)/comprising," "include(s)/including," "have/has/having" or similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

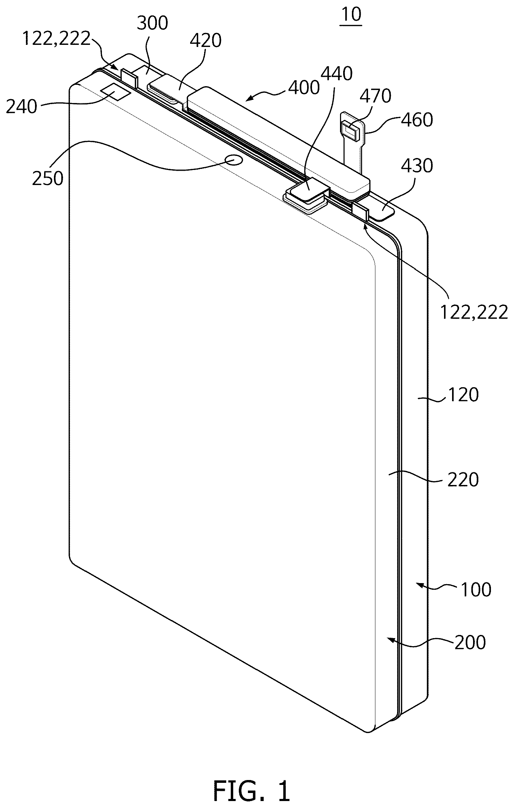

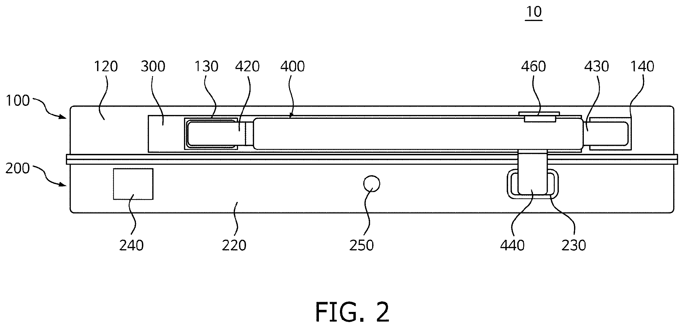

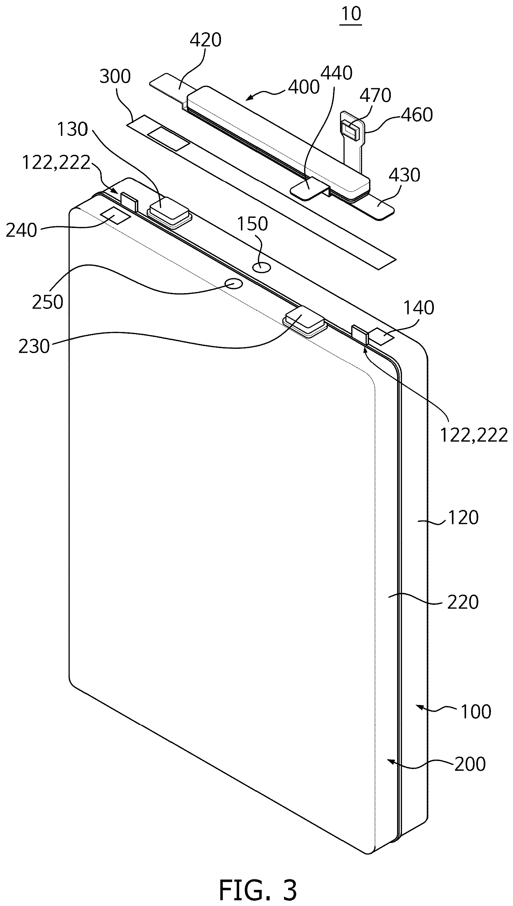

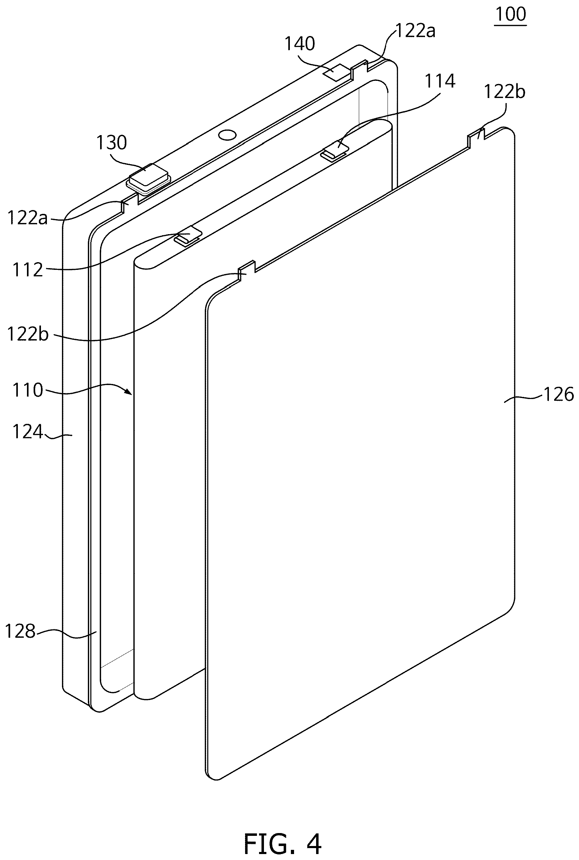

FIG. 1 illustrates a perspective view of a battery module according to one or more embodiments of the present disclosure. FIG. 2 illustrates a plan view of a battery module according to one or more embodiments of the present disclosure. FIG. 3 illustrates an exploded view of a battery module according to one or more embodiments of the present disclosure. FIG. 4 illustrates an exploded view of an electrode assembly and a case according to one or more embodiments of the present disclosure.

Referring to FIGS. 1 to 4, a battery module 10 may include a first battery cell 100, a second battery cell 200, an insulating part 300, and a protection circuit module 400.

The first battery cell 100 may include a first electrode assembly 110, a first case 120 that accommodates the first electrode assembly 110, and at least one first flange portion 122 formed on the first case 120.

The first electrode assembly 110 may include a first electrode, a second electrode, and a separator. In one or more embodiments, the first electrode may serve as a positive electrode, and the second electrode may serve as a negative electrode. For example, the first electrode assembly 110 may be configured as a winding-type (kind) electrode assembly formed by winding the first and second electrodes together with the separator, which serves as an insulator, interposed between the first and second electrodes. In other embodiments, the first electrode assembly 110 may be configured as a stack-type (kind) electrode assembly formed by alternately stacking the first and second electrodes with the separator in between or may have any structure including the first and second electrodes. The structure of the first electrode assembly 110 described above is provided by way of example only, and the present disclosure is not limited thereto.

The first electrode assembly 110 may further include a first electrode tab 112 and a second electrode tab 114. The first electrode tab 112 may be separately formed and connected to an uncoated portion of the first electrode, or the first electrode tab 112 may be formed by punching out a part of the uncoated portion of the first electrode. The first electrode tab 112 may extend outward from the uncoated portion and come into contact with a first electrode terminal 130. The first electrode tab 112 serves as a pathway for current flow between the first electrode and the first electrode terminal 130. The second electrode tab 114 may be separately formed and connected to an uncoated portion of the second electrode, or the second electrode tab 114 may be formed by punching out a part of the uncoated portion of the second electrode. The second electrode tab 114 may extend outward from the uncoated portion of the second electrode and come into contact with the first case 120. The second electrode tab 114 may directly contact the first case 120 (or a body portion 124 to be described in more detail later) or may contact a negative electrode terminal provided on an inner side of the first case 120. In one or more embodiments, the negative electrode terminal may be provided on an outer side of the first case 120. The second electrode tab 114 may serve as a pathway for current flow between the second electrode and the first case 120.

The first case 120 may form an overall outer appearance of the first battery cell 100. In one or more embodiments, the first case 120 may be formed of stainless steel (SUS). In one or more embodiments, the first case 120 may be formed of a conductive metal, such as aluminum, an aluminum alloy, or nickel-plated steel. In one or more embodiments, a thickness of the first case 120 may be in a range of about 0.05 mm to 0.5 mm. In one or more embodiments, a thickness of the first case 120 may be in a range of about 0.05 mm to 0.1 mm. However, the thickness values provided for the first case 120 are merely examples, and the present disclosure is not limited thereto.

The first case 120 may include a body portion 124 and a case cover 126.

The body portion 124 may have a first open surface (*e.g*., a first surface defining an opening) to accommodate the first electrode assembly 110. Along the periphery of the first open surface, the body portion 124 may include a sealing portion 128 that contacts the case cover 126. The sealing portion 128 may contact and may be joined with the case cover 126 by welding.

The case cover 126 may cover the first open surface of the body portion 124 and seal the first electrode assembly 110 from the external environment. The case cover 126 may have a planar shape. The case cover 126 may contact the sealing portion 128 and may be coupled with the body portion 124 by welding performed along the periphery of the body portion 124.

The first flange portion 122 may include a body flange portion 122a formed on the body portion 124 and a cover flange portion 122b formed on the case cover 126. The body portion 124 may include at least one body flange portion 122a. Similarly, the case cover 126 may include at least one cover flange portion 122b. The at least one body flange portion 122a and the at least one cover flange portion 122b may be formed at positions corresponding to each other.

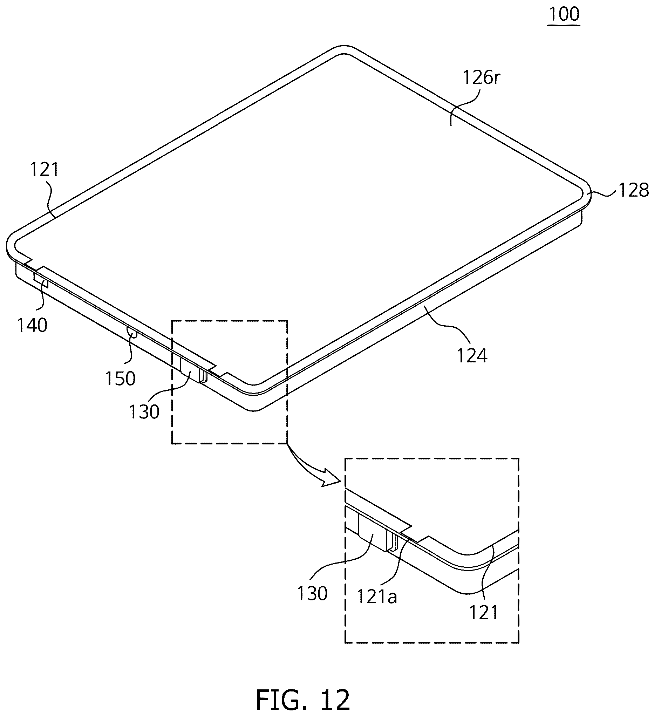

In one or more embodiments, the cover flange portion 122b may be formed on the same plane as the case cover 126. The cover flange portion 122b may protrude from one side of the periphery of the case cover 126. For example, in the process of welding the planar metallic case cover 126 to the body portion 124, a welding line 121 *(see, e.g.,* FIG. 12) may be set and the welding may be performed along the welding line 121 such that one side of the case cover 126 protrudes. Subsequently, at least one first flange portion 122 may be formed through cutting and grinding processes.

A first side surface of the first case 120 may include the first electrode terminal 130, a second electrode terminal 140, and an electrolyte injection hole 150.

The first electrode terminal 130 may be formed through the first side surface of the first case 120. An insulating gasket may be provided between the first electrode terminal 130 and the first case 120, allowing the first electrode terminal 130 to be electrically insulated from the first case 120 through the insulating gasket. The first electrode terminal 130 may be electrically connected to the first electrode of the first electrode assembly 110. For example, the first electrode terminal 130 may be electrically connected to the first electrode through the first electrode tab 112. By being electrically connected to the first electrode, the first electrode terminal 130 may serve as the positive electrode.

The first electrode terminal 130 may be electrically connected to the protection circuit module 400. The first electrode terminal 130 may be electrically connected to the protection circuit module 400 through a first connection tab 420. The first electrode terminal 130 may be joined to the first connection tab 420 by welding, but the present disclosure is not limited thereto.

The second electrode terminal 140 may be arranged on the first side surface of the first case 120. The second electrode terminal 140 may be spaced and/or apart (*e.g*., spaced apart or separated) from the first electrode terminal 130. The second electrode terminal 140 may be electrically connected to the first case 120. Unlike the first electrode terminal 130, the second electrode terminal 140 may be formed in contact with the first case 120. The second electrode terminal 140 may be electrically connected to the second electrode of the first electrode assembly 110. For example, the first case 120 may be electrically connected to the second electrode through the second electrode tab 114. The second electrode terminal 140 may be electrically connected to the second electrode through the first case 120 and the second electrode tab 114. By being electrically connected to the second electrode, the first case 120 and the second electrode terminal 140 may serve as the negative electrode.

The second electrode terminal 140, having the same polarity as the first case 120, may be positioned in contact with the first case 120 to address potential welding damage. The first case 120 made of a stainless steel thin film may be vulnerable to damage during the welding process with external terminals or connection tabs. To address this issue, the second electrode terminal 140, which has higher rigidity for weldability, may be attached to the first case 120 to ensure reliable welding connections with the external terminals. For example, in embodiments in which the second electrode terminal 140 is omitted and the first case 120 is directly joined with the second connection tab 430 by welding, a welding depth or other related factors may result in leakage from the first case 120 or damage to the electrode assembly accommodated in the first case 120. To prevent or reduce such issues, the second electrode terminal 140, which has sufficiently high rigidity for welding and excellent or suitable weldability with the first case 120 and the second connection tab 430, may be positioned in contact with the first case 120.

The second electrode terminal 140 may include a second electrode plate with sufficiently high rigidity for welding and excellent or suitable weldability. The second electrode plate may include a nickel (Ni) alloy, but the present disclosure is not limited thereto. The second electrode plate may be attached to the first case 120 through ultrasonic welding, but the present disclosure is not limited thereto.

The second electrode terminal 140 may be electrically connected to the protection circuit module 400. For example, the second electrode terminal 140 may be electrically connected to the protection circuit module 400 through the second connection tab 430. The second electrode terminal 140 may be joined to the second connection tab 430 by welding, but the present disclosure is not limited thereto.

The electrolyte injection port 150 may be formed on the first side surface of the first case 120. The electrolyte injection hole 150 may be formed between the first electrode terminal 130 and the second electrode terminal 140, but the present disclosure is not limited thereto and the electrolyte injection hole 150 may instead be formed in any region of the first side surface or on another side surface of the first case 120. The electrolyte injection hole 150 may be sealed with a sealing member after the electrolyte is injected.

The second battery cell 200 may include a second electrode assembly, a second case 220 that accommodates the second electrode assembly, and at least one second flange portion 222 formed on the second case 220.

The second battery cell 200 has substantially the same structure as the first battery cell 100 described above. Therefore, a detailed description thereof may not be provided to avoid redundancy.

A third electrode terminal 230 of the second battery cell 200, which has the same or similar configuration as the first electrode terminal 130 of the first battery cell 100, may be electrically connected to the protection circuit module 400 arranged on the first battery cell 100. The third electrode terminal 230 of the second battery cell 200 may be electrically connected to the protection circuit module 400 through a third connection tab 440. As will be described in more detail later, the first electrode terminal 130 of the first battery cell 100 and the third electrode terminal 230 of the second battery cell 200 may be electrically connected through a wiring circuit provided within the protection circuit module 400.

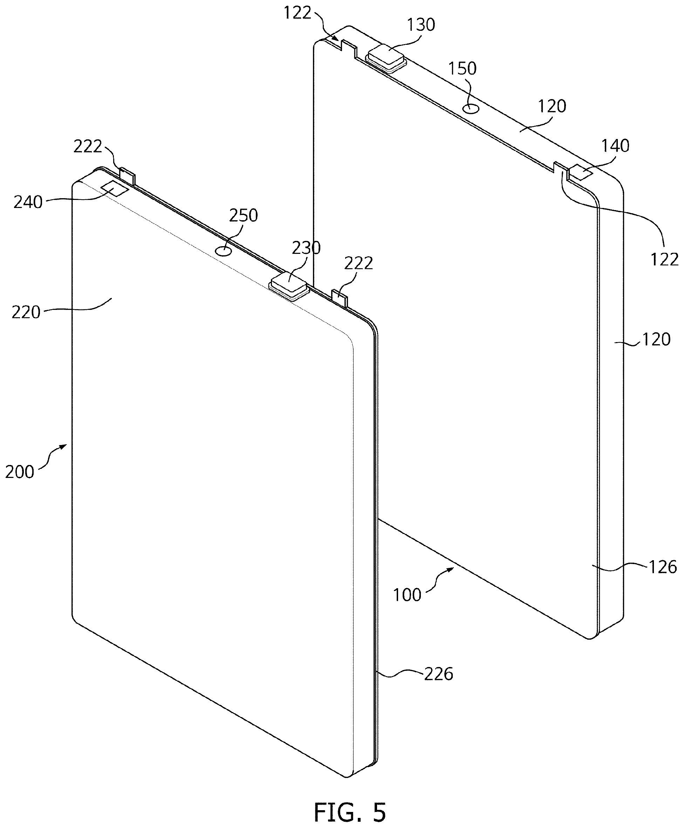

The case cover 126 of the first battery cell 100 and the case cover 226 (*see, e.g*., FIG. 5) of the second battery cell 200 may be connected so as to face each other. An adhesive material may be applied between the case cover 126 of the first battery cell 100 and the case cover 226 of the second battery cell 200 to securely fix and/or join the first battery cell 100 and the second battery cell 200.

At least one first flange portion 122 of the first battery cell 100 and at least one second flange portion 222 of the second battery cell 200 may be connected to each other. For example, at least one first flange portion 122 and at least one second flange portion 222 may be joined by welding.

The first case 120 of the first battery cell 100 and the second case 220 of the second battery cell 200, which serve as the negative electrodes, may be electrically connected through at least one first flange portion 122 and at least one second flange portion 222 that are welded together. For example, after the first battery cell 100 and the second battery cell 200 are fixed by applying an adhesive member between the case cover 126 of the first battery cell 100 and the case cover 226 of the second battery cell 200, at least one first flange portion 122 and at least one second flange portion 222 may be welded together to electrically connect the first case 120 of the first battery cell 100 and the second case 220 of the second battery cell 200. For example, the first case 120, electrically connected to the second electrode (serving as the negative electrode) of the first electrode assembly 110, and the second case 220, electrically connected to a fourth electrode (serving as the negative electrode) of the second electrode assembly, may be electrically connected via the first flange portion 122 and the second flange portion 222 without requiring a separate connection device. This approach differs from the electrical connection between the first electrode (serving as the positive electrode) of the first battery cell 100 and the third electrode (serving as the positive electrode) of the second battery cell 200, which is achieved through a wiring circuit in the protection circuit module 400. Instead, the second electrode (serving as the negative electrode) of the first battery cell 100 and the fourth electrode (serving as the negative electrode) of the second battery cell 200 may be electrically connected in parallel through the first flange portion 122 and the second flange portion 222. Accordingly, the first battery cell 100 and the second battery cell 200 may be connected in parallel.

The insulating part 300 may be arranged on the first side surface of the first case 120. The insulating part 300 may be positioned between the first electrode terminal 130 and the second electrode terminal 140. The insulating part 300 may provide electrical insulation between the first connection tab 420, which is connected to the first electrode terminal 130, and the first case 120. Additionally, the insulating part 300 may provide electrical insulation between the third connection tab 440, which is connected to the third electrode terminal 230, and the first case 120. For example, the insulating part 300 may provide electrical insulation between the first connection tab 420 and the third connection tab 440, which serve as the positive electrode, and the first case 120, which serves as the negative electrode.

The protection circuit module 400 may be electrically connected to the first battery cell 100 and the second battery cell 200 to prevent or reduce the likelihood of overheating and explosion resulting from overcharging, over-discharging, and/or overcurrent in the first battery cell 100 and/or the second battery cell 200. The protection circuit module 400 may include protection circuit devices that may include safety elements, such as passive elements (*e.g*., resistors and capacitors) and/or active elements (*e.g.,* field-effect transistors), and/or integrated circuits.

The protection circuit module 400 may be arranged on the first battery cell 100. For example, the protection circuit module 400 may be positioned on the first side surface where the first electrode terminal 130 and the second electrode terminal 140 are located. The protection circuit module 400 may include first to third connection tabs 420, 430, 440, a lead-out portion 460, and a connector 470.

The first connection tab 420 may connect the first electrode terminal 130 of the first battery cell 100 to the protection circuit module 400. The second connection tab 430 may connect the second electrode terminal 140 of the first battery cell 100 to the protection circuit module 400. The third connection tab 440 may connect the third electrode terminal 230 of the second battery cell 200 to the protection circuit module 400. The first to third connection tabs 420, 430, and 440 may include materials with high electrical conductivity. For example, the first to third connection tabs 420, 430, and 440 may include highly conductive metals such as gold, silver, copper, or nickel, but the present disclosure is not limited to these materials.

The lead-out portion 460 may extend from a portion between the first connection tab 420 and the second connection tab 430. A connector 470, which is connected to an external device, may be arranged on a first surface of the lead-out portion 460. The protection circuit module 400 may be connected to the external device through the connector 470. Through the connector 470, the protection circuit module 400 may be to transmit the electrical energy stored in the first battery cell 100 and the second battery cell 200 to the external device and/or to receive control signals from the external device to control the operation of the first battery cell 100 and the second battery cell 200.

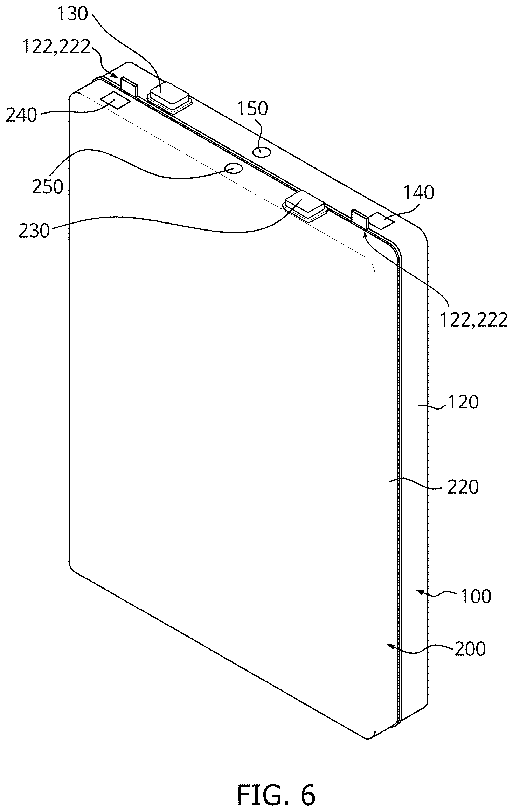

FIG. 5 illustrates an exploded view of a structure prior to an assembly of a first battery cell and a second battery cell according to one or more embodiments of the present disclosure. FIG. 6 illustrates an exploded view of a structure after an assembly of a first battery cell and a second battery cell according to one or more embodiments of the present disclosure.

Referring to FIG. 5, the case cover 126 of the first battery cell 100 and the case cover 226 of the second battery cell 200 may be arranged to face each other. The first flange portion 122 formed on the first battery cell 100 and the second flange portion 222 formed on the second battery cell 200 may be symmetrical with respect to the opposing case covers. In other words, the first flange portion 122 of the first battery cell 100 may be positioned to face and/or to be opposite to the second flange portion 222 of the second battery cell 200 when the case cover 126 and the case cover 226 face (or are opposite) to one another.

Referring to FIG. 6, an adhesive material may be applied between the case cover 126 of the first battery cell 100 and the case cover 226 of the second battery cell 200 *(see, e.g.,* FIG. 5), allowing the first battery cell 100 and the second battery cell 200 to be securely joined. After respectively applying adhesive members to the case covers 126 and 226 to fix the first battery cell 100 and the second battery cell 200, the first flange portion 122 and the second flange portion 222 may be welded together.

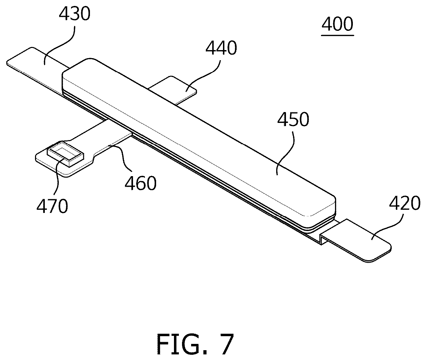

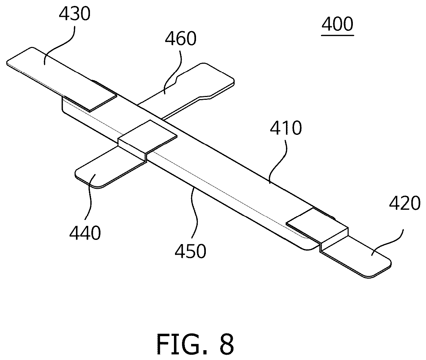

FIG. 7 illustrates a top perspective view of a protection circuit module according to one or more embodiments of the present disclosure. FIG. 8 illustrates a bottom perspective view of a protection circuit module according to one or more embodiments of the present disclosure.

Referring to FIGS. 7 and 8, the protection circuit module may include a substrate 410, the first to third connection tabs 420, 430, and 440, a substrate cap 450, the lead-out portion 460, and the connector 470.

Protection circuit devices that may include safety elements such as passive elements (*e.g*., resistors and capacitors) and/or active elements (*e.g*., field-effect transistors), and/or integrated circuits may be integrated on the substrate 410.

The substrate 410 may be to transmit and/or receive electrical signals through printed wiring. The substrate 410 may be a flexible printed circuit board (FPCB), but the present disclosure is not limited thereto.

A bottom surface of the substrate 410 may be provided with separate terminals to enable welding connections with the first to third connection tabs 420, 430, and 440. The substrate 410 may be connected to the first to third connection tabs 420, 430, and 440 through these terminals.

The first connection tab 420 may electrically connect the first electrode terminal 130 of the first battery cell 100 to the protection circuit module 400. The second connection tab 430 may electrically connect the second electrode terminal 140 of the first battery cell 100 to the protection circuit module 400. The third connection tab 440 may electrically connect the third electrode terminal 230 of the second battery cell 200 to the protection circuit module 400.

The first electrode terminal 130 and the third electrode terminal 230 may be electrically connected through a wiring circuit formed within the substrate.

The substrate cap 450 may be arranged on the substrate 410 while covering the substrate 410. The substrate cap 450 may be formed by molding a resin material over the protection circuit devices on the substrate 410.

The lead-out portion 460 may extend from a portion between the first connection tab 420 and the second connection tab 430. The connector 470, configured to connect to an external device, may be arranged on a first surface of the lead-out portion 460.

The connector 470 may be connected to an external device. The protection circuit module 400 may establish a connection with the external device through the connector 470. Through the connector 470, the protection circuit module 400 may be to transmit the electrical energy stored in the first battery cell 100 and the second battery cell 200 to the external device. Additionally, the protection circuit module 400 may receive control signals from the external device to control the operation of the first battery cell 100 and the second battery cell 200.

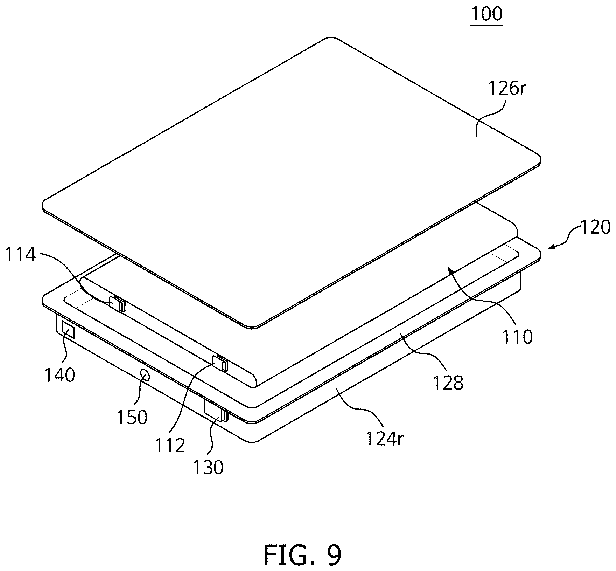

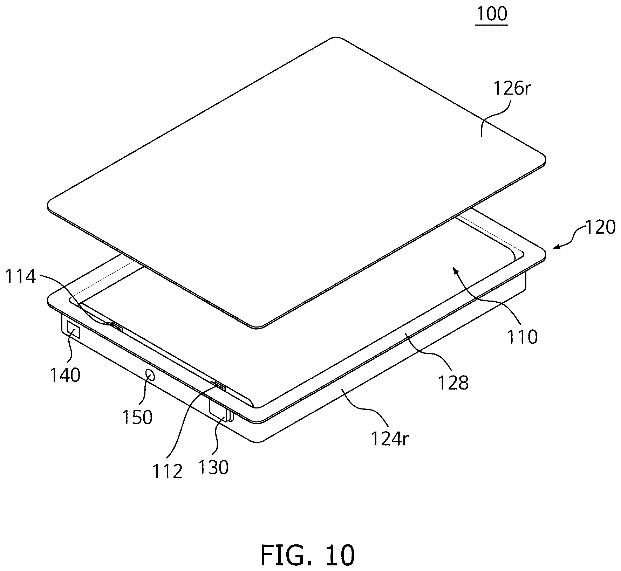

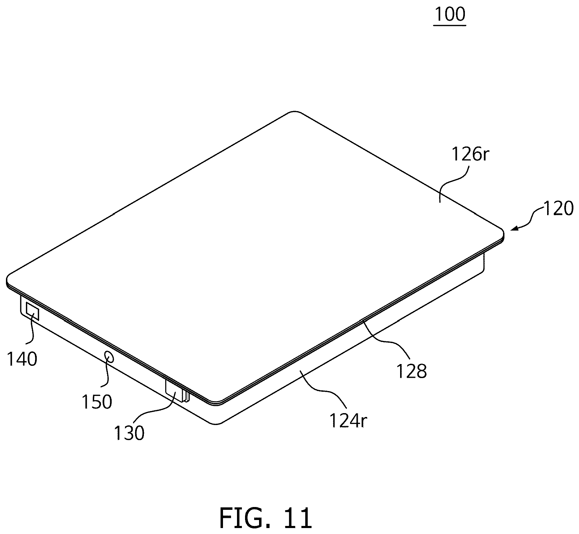

FIGS. 9 to 13 illustrate perspective views of a process of manufacturing a first battery cell according to one or more embodiments of the present disclosure.

Referring to FIGS. 9 to 13, the first electrode assembly 110 may be accommodated within an original body portion 124r of the first case 120, which has a first open surface. The original body portion 124r may include a receiving space configured to accommodate the first electrode assembly 110 and a sealing portion 128 formed along the periphery of the first open surface. As the first electrode assembly 110 is accommodated within the receiving space of the original body portion 124r, the first electrode tab 112 may come into contact with the first electrode terminal 130, and the second electrode tab 114 may either come into direct contact with the original body portion 124r or contact the negative electrode terminal provided on an inner side of the original body portion 124r.

After the first electrode assembly 110 is accommodated within the original body portion 124r of the first case 120, the first electrode assembly 110 may be sealed by covering the first open surface of the original body portion 124r with an original case cover 126r. The original case cover 126r may be a planar rectangular metal sheet. The original case cover 126r may be welded along its periphery while in contact with the sealing portion 128, thereby coupling the original case cover 126r to the original body portion 124r.

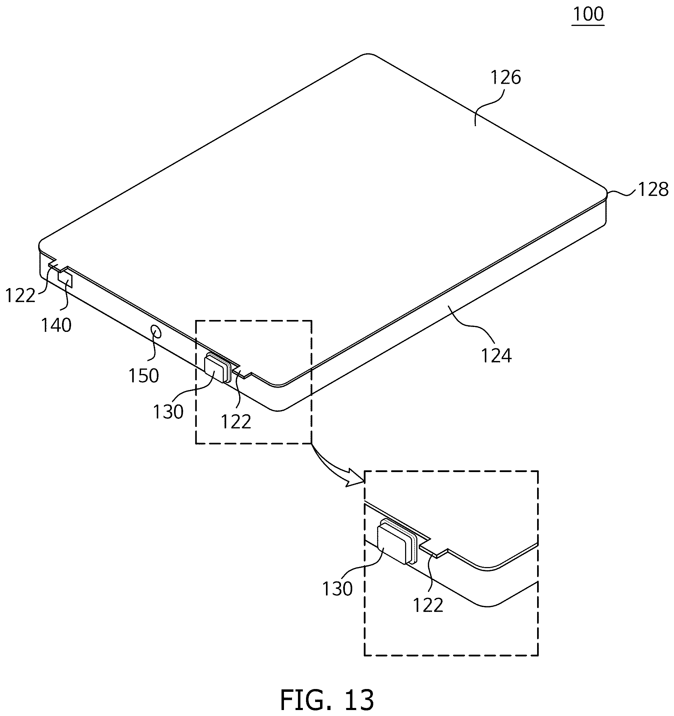

During the welding process, a welding line 121 may be defined to form the first flange portion 122 at one side of each of the body portion 124 and the case cover 126. In embodiments in which the body portion 124 and the case cover 126 are welded along the welding line 121, a welding line 121a having a protruding shape at one side may be formed. The first flange portion 122 may be formed at one side of the case 120 by cutting and grinding the original body portion 124r and the original case cover 126r along the welding line 121. For example, the body portion 124 including the body flange portion 122a *(see, e.g.,* FIG. 4) and the case cover 126 including the cover flange portion 122b *(see, e.g.,* FIG. 4) may be formed by sealing the original body portion 124r and the planar-shaped original case cover 126r by welding *(see, e.g.,* FIG. 12), followed by cutting the original body portion 124r and the original case cover 126r *(see, e.g.,* FIG. 13) to form the body portion 124 and the case cover 126 including the first flange portion 122.

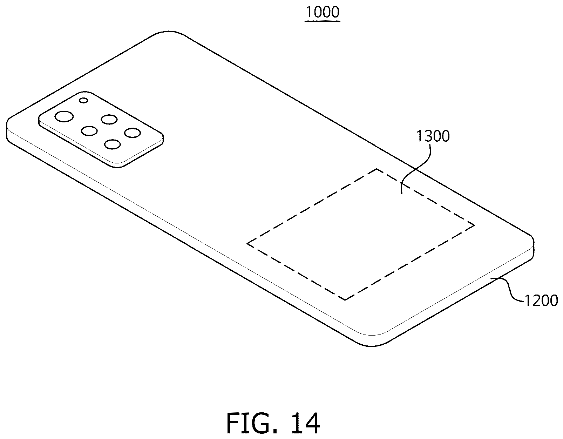

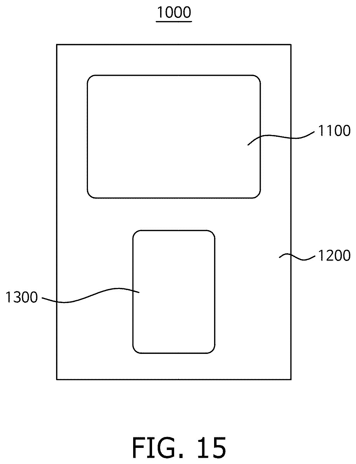

FIG. 14 illustrates a schematic perspective view of an electronic apparatus including a battery according to one or more embodiments of the present disclosure. FIG. 15 illustrates a schematic view of a battery module arranged within an electronic apparatus according to one or more embodiments of the present disclosure.

Referring to FIGS. 14 and 15, an electronic apparatus 1000 according to one or more embodiments of the present disclosure may include an operation unit 1100 configured to perform set or predetermined operations, a housing 1200 that accommodates the operation unit 1100 therein, and a battery module 1300 that is fixed within the housing 1200 to supply power to the operation unit 1100.

The electronic apparatus 1000, including the battery module 1300, may be a smartphone, but the present disclosure is not limited thereto. For example, the electronic apparatus 1000 may be used in one or more suitable apparatuses that utilize the electrical energy stored in the battery module 1300 and for which it may be desirable to have a protection circuit.

The operation unit 1100 may include one or more suitable hardware components driven by electrical energy supplied from the battery module 1300. For example, the operation unit 1100 may include an application processor (AP) and a central processing unit (CPU) for a portable electronic device.

In one or more embodiments, a printed circuit board, including signal transmission wiring, may be arranged inside the housing 1200. The operation unit 1100 may be mounted on the printed circuit board and may be electrically connected to other components of the electronic apparatus 1000.

The housing 1200 may accommodate therein the operation unit 1100 and the battery module 1300, and provide the overall outer appearance of the electronic apparatus 1000. The housing 1200 may be configured in one or more suitable structural forms as long as it can support and protect the operation unit 1100 and the battery module 1300 arranged therein from external impacts.

The battery module 1300 may be fixed within the housing 1200 to reliably supply power to the operation unit 1100. For example, the battery module 1300 may configured as a rechargeable secondary battery. The battery module 1300 may have a configuration substantially identical to that of the battery module 10 described with reference to FIGS. 1 to 13.

For example, the battery module 1300 may be arranged in a power region within the housing 1200 and connected to the terminals of the printed circuit board. Accordingly, the operation unit 1100 may be driven using the electric energy stored in the first battery cell 100 and the second battery cell 200.

The battery module 1300 may include a first battery cell including a first case accommodating a first electrode assembly and a first flange portion formed on the first case, and a second battery cell including a second case accommodating a second electrode assembly and a second flange portion formed on the second case. The first flange portion and the second flange portion may be connected to each other, and the first case of the first battery cell and the second case of the second battery cell may be electrically connected to each other through the first flange portion and the second flange portion.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

The electronic device, battery module, and/or battery, *e.g*., a battery controller, and/or any other relevant devices or components according to embodiments of the present disclosure described herein may be implemented utilizing any suitable hardware, firmware (*e.g*., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

A person of ordinary skill in the art, in view of the present disclosure in its entirety, would appreciate that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

Although the present disclosure has been described above with respect to embodiments thereof, the present disclosure is not limited thereto. Various modifications and variations can be made thereto by those skilled in the art within the scope of the present disclosure.

### Description of Symbols

| | | | |
|---|---|---|---|
| 10: | battery module | 100: | first battery cell |
| 110: | first electrode assembly | 120: | first case |
| 122: | first flange portion | 130: | first electrode terminal |
| 140: | second electrode terminal | 150: | electrolyte injection hole |
| 200: | second battery cell | 220: | second case |
| 222: | second flange portion | 230: | third electrode terminal |
| 240: | fourth electrode terminal | 250: | electrolyte injection hole |
| 300: | insulating part | 400: | protection circuit module |
| 410: | substrate | 420: | first connection tab |
| 430: | second connection tab | 440: | third connection tab |
| 450: | substrate cap | 460: | lead-out portion |
| 470: | connector | | |

## Claims

1. A battery module (10) comprising:
a first battery cell (100) comprising a first electrode assembly (110), a first case (120) accommodating the first electrode assembly (110), and a first flange portion (122) on the first case (120); and
a second battery cell (200) comprising a second electrode assembly, a second case (220) accommodating the second electrode assembly, and a second flange portion (222) on the second case (220),
wherein the first flange portion (122) and the second flange portion (222) are connected to each other.

2. The battery module (10) as claimed in claim 1, wherein the first flange portion (122) comprises a body flange portion (122a) and a cover flange portion (122b), and
the first case (120) comprises:
a body portion (124) comprising the body flange portion (122a), the body portion (124) having a first surface defining an opening that accommodates the first electrode assembly (110); and
a case cover (126) comprising the cover flange portion (122b), the case cover (126) covering the first surface of the body portion (124) and sealing the first electrode assembly (110).

3. The battery module (10) as claimed in claim 2, wherein the cover flange portion (122b) and the case cover (126) are a single piece and located in a single plane.

4. The battery module (10) as claimed in claim 1, wherein the first battery cell (100) and the second battery cell (200) are connected and a case cover (126) of the first case (120) and a case cover (226) of the second case (220) face each other.

5. The battery module (10) as claimed in claim 4, wherein an adhesive material is between the case cover (126) of the first case (120) and the case cover (226) of the second case (220) so that the first battery cell (100) and the second battery cell (200) are fixedly coupled to each other.

6. The battery module (10) as claimed in any one of claims 1 to 5, wherein the first flange portion (122) is welded to the second flange portion (222).

7. The battery module (10) as claimed in any one of claims 1 to 6, wherein each of the first case (120) and the second case (220) has a thickness in a range of about 0.05 mm to 0.1 mm.

8. The battery module (10) as claimed in claim 2 or claim 3, wherein the body portion (124) comprising the body flange portion (122a) and the case cover (126) comprising the cover flange portion (122b) are sealed along a welding line (121) defining the first flange portion (122).

9. The battery module (10) as claimed in any one of claims 1 to 8, wherein the first battery cell (100) comprises a first electrode terminal (130) on the first case (120) and a second electrode terminal (140) in contact with the first case (120),
the second battery cell (200) comprises a third electrode terminal (230) on the second case (220) and a fourth electrode terminal (240) in contact with the second case (220), and
the first case (120) of the first battery cell (100) and the second case (220) of the second battery cell (200) are electrically connected to each other through the first flange portion (122) and the second flange portion (222).

10. The battery module (10) as claimed in claim 9, wherein each of the second electrode terminal (140) and the fourth electrode terminal (240) comprises an electrode plate comprising a nickel (Ni) alloy.

11. The battery module (10) as claimed in any one of claims 1 to 10, further comprising a protection circuit module (400) on the first battery cell (100) and connected to both the first battery cell (100) and the second battery cell (200).

12. The battery module (10) as claimed in claim 11, wherein the first battery cell (100) comprises a first electrode terminal (130) on the first case (120) and a second electrode terminal (140) in contact with the first case (120), and
the second battery cell (200) comprises a third electrode terminal (230) on the second case (220) and a fourth electrode terminal (240) in contact with the second case (220), and
wherein the protection circuit module (400) comprises:
a first connection tab (420) connecting the first electrode terminal (130) of the first battery cell (100) and the protection circuit module (400);
a second connection tab (430) connecting the second electrode terminal (140) of the first battery cell (100) and the protection circuit module (400); and
a third connection tab (440) connecting the third electrode terminal (230) of the second battery cell (200) and the protection circuit module (400).

13. The battery module (10) as claimed in claim 12, wherein the first electrode terminal (130) and the third electrode terminal (230) are electrically connected to each other through the protection circuit module (400), and
the second electrode terminal (140) and the fourth electrode terminal (240) are electrically connected to each other through the first flange portion (122) and the second flange portion (222).

14. The battery module (10) as claimed in any one of claims 11 to 13, wherein the protection circuit module (400) comprises:
a substrate (410) on which protection circuit devices are integrated;
a lead-out portion (460) extending from one side of the substrate (410); and
a connector (470) on a surface of the lead-out portion (460) to connect to an external device.

15. The battery module (10) as claimed in claim 14, wherein the substrate (410) comprises a flexible printed circuit board (FPCB).
